# EUROPEAN PATENT APPLICATION

(11) **EP 4 575 536 A1**
(43) Date of publication of application: **25.06.2025**
(21) Application number: 24218804.3
(22) Date of filing: 10.12.2024
(51) Int. Cl.: G01R 31/3185

(54) **SCAN FLIP-FLOP**

(30) Priority: 15.12.2023 IN 202311085878
(71) Applicant: NXP B.V., 5656 AG Eindhoven (NL)
(72) Inventor: Gayakwad, Pramod, 5656AG Eindhoven (NL); Dharmavaram, Ramanath, 5656AG Eindhoven (NL); Kaliyur Palaniappan, Chandhramohan, 5656AG Eindhoven (NL); Schat, Jan-Peter, 5656AG Eindhoven (NL)
(74) Representative: Miles, John Richard

(57) **Abstract**

The disclosure relates to a scan flip-flop device and associated methods for operating a circuit comprising a scan flip-flop device. An example scan flip-flop device comprises: a multiplexer configured to receive a data signal, a scan input signal and a scan enable signal; a flip-flop configured to receive the output of the multiplexer and a clock signal, and the flip-flop being also configured to provide an output signal; a first logic gate configured to receive the flip-flop output signal and a first test signal; and a second logic gate configured to receive the flip-flop output signal and a second test signal, wherein the scan enable signal, first test signal and second test signal are independently configurable.

## Description

### Field

The disclosure relates to a scan flip-flop device and a method of operating a circuit comprising a scan flip-flop device.

### Background

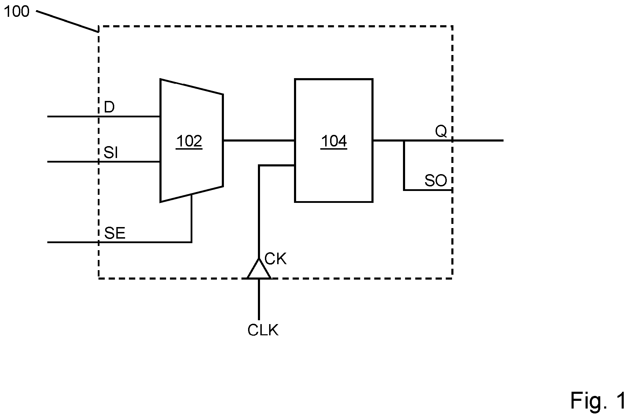

Scan flip-flops are devices that are widely used for implementing Design for Testing (DfT) mechanisms in integrated circuits (ICs). An example scan flip-flop 100 is schematically illustrated in Figure 1. The scan flip-flop 100 comprises a multiplexer 102 that is provided with a data signal D and a scan input signal SI, and is configured to pass either of the signals dependent upon a scan enable signal SE (thereby switching the scan flip-flop 100 between a functional/operational mode and a scan/test mode). The scan flip-flop device 100 further comprises a flip-flop 104 (a device that can be switched between two stable states) that receives the output of the multiplexer 102 and a clock signal CK provided by an external clock reference signal CLK. The flip-flop 104 outputs signals Q and SO dependent on the state of the flip-flop 104. The Q signal is provided as a functional output for combinational logic circuit, while the SO signal is provided as a scan output.

Multiple scan flip-flops can be connected in series in order to form a scan chain. By switching the scan flip-flops to the scan mode and providing a suitable SI and CLK signal, a scan pattern can be applied to the scan chain. Testing of the scan flip-flops can be performed by loading the scan pattern to the scan chain, applying the scan pattern to the scan flip-flops, and observing an output of the scan chain. Therefore, the scan chain may be used to provide testing of an IC in which the scan flip-flops are integrated.

However, as the number of scan flip-flops in the scan chain increases, the power consumption associated with switching the scan flip-flops between the functional mode and the scan mode also increases. This can result in relatively large power consumption for larger scan chains. Additionally, scan flip-flops like those of Figure 1 may not be able to provide sufficient test coverage for various fault types, at least not with compromising excessive power consumption.

### Summary

According to a first aspect, there is provided a scan flip-flop device. The scan flip-flop device comprises:
a multiplexer configured to receive a data signal, a scan input signal and a scan enable signal, the multiplexer being configured to selectively output either the data signal or the scan input signal based upon the scan enable signal;
a flip-flop configured to receive the output of the multiplexer and a clock signal, the flip-flop being configured to output a flip-flop signal based on a state of the flip-flop;
a first logic gate configured to receive the flip-flop signal and a first test signal, the first logic gate being configured to output a first output based on a comparison of the flip-flop signal and a first test signal; and
a second logic gate configured to receive the flip-flop signal and a second test signal, the second logic gate being configured to output a second output based on a comparison of the flip-flop signal and a second test signal,
wherein the scan enable signal, first test signal and second test signal are independently configurable.

Providing an independently configurable first test signal and second test signal may advantageously reduce power consumption by the scan flip-flop device and/or a combinational logic that receives inputs from the scan flip-flop device. The test signals may be used to provide power gating to the first and/or second outputs of the device. This may provide power savings, particularly during a scan shift phase of the device.

The independently configurable first and second test signals may also advantageously provide for greater test coverage and/or functionality of the scan flip-flop device. By using the test signals to control the first and second logic gates, thereby adjusting the output signal of the device, various test conditions can be implemented. The scan flip-flop device of the present disclosure may, for example, enable support for Bias Temperature Instability (BTI) recovery, logic built-in self-test (LBIST) and local pseudo-launch-off-shift (PLOS) transition scan testing.

Such power savings and test coverage may be particularly important for certain integrated circuits (e.g., high frequency system on chip (SoC) design using lower geometry process nodes such as 16 nm and below) or for certain applications (e.g., automotive applications), where power consumption and functional safety are critical.

The first logic gate may be an OR gate.

The second logic gate may be an AND gate.

The flip-flop may comprise a reset and/or set pin configured to reset or set the state of the flip-flop in response to a reset and/or set signal.

According to a second aspect, there is provided a multi-bit scan flip-flop device. The multi-bit scan flip-flop device comprises at least a first scan flip-flop device and a second scan flip-flop device, wherein each of the scan flip-flop devices comprises:
a multiplexer configured to receive a data signal, a scan input signal and a scan enable signal, the multiplexer being configured to selectively output either the data signal or the scan input signal based upon the scan enable signal;
a flip-flop configured to receive the output of the multiplexer and a clock signal, the flip-flop being configured to output a flip-flop signal based on a state of the flip-flop;
a first logic gate configured to receive the flip-flop signal and a first test signal, the first logic gate being configured to output a first output based on a comparison of the flip-flop signal and a first test signal; and
a second logic gate configured to receive the flip-flop signal and a second test signal, the second logic gate being configured to output a second output based on a comparison of the flip-flop signal and a second test signal, wherein the first output of the first scan flip-flop device and the data signal received by the second scan flip-flop device are coupled to combinational logic such that the first scan flip-flop device outputs to the combinational logic and the second scan flip-flop device receives an input from the combinational logic when the multi-bit scan flip-flop device is operated in a functional or scan capture mode.

Each of the first scan flip-flop device and the second scan flip-flop device may be provided with an individual scan input signal.

The second output of the first scan flip-flop device may be provided as the scan input signal received by the second scan flip-flop device.

The scan enable signals provided to the first scan flip-flop device and second scan flip-flop device may be synchronised using an integrated synchroniser. The first scan flip-flop device may output to the combinational logic and the second scan flip-flop device may receive an integrated synchroniser input from the combinational logic, when the multi-bit scan flip-flop device is operated in a functional and/or scan capture mode.

According to a third aspect, there is provided a pseudo-launch-off-shift, PLOS, circuit. The PLOS circuit comprises:
a scan flip-flop device comprising:
   a multiplexer configured to receive a data signal, a scan input signal and a scan enable signal, the multiplexer being configured to selectively output either the data signal or the scan input signal based upon the scan enable signal;
   a flip-flop configured to receive the output of the multiplexer and a clock signal, the flip-flop being configured to output a flip-flop signal based on a state of the flip-flop;
   a first logic gate configured to receive the flip-flop signal and a first test signal, the first logic gate being configured to output a first output based on a comparison of the flip-flop signal and a first test signal; and
   a second logic gate configured to receive the flip-flop signal and a second test signal, the second logic gate being configured to output a second output based on a comparison of the flip-flop signal and a second test signal,
   wherein the scan enable signal, first test signal and second test signal are independently configurable; and
a PLOS synchroniser configured to provide a synchronised scan enable signal to the scan flip-flop device such that the selective output of multiplexer is synchronised with the clock signal.

The PLOS synchroniser may be configured to provide a synchronised scan enable signal to the scan flip-flop even after the clock signal frequency changes from low to high, or 0 to 1, value.

According to a fourth aspect, there is provided a multi-bit pseudo-launch-off-shift, PLOS, circuit. The multi-bit PLOS circuit comprises:
a multi-bit scan flip-flop device comprising at least a first scan flip-flop device and a second scan flip-flop device, wherein each of the scan flip-flop devices comprises:
   a multiplexer configured to receive a data signal, a scan input signal and a scan enable signal, the multiplexer being configured to selectively output either the data signal or the scan input signal based upon the scan enable signal;
   a flip-flop configured to receive the output of the multiplexer and a clock signal, the flip-flop being configured to output a flip-flop signal based on a state of the flip-flop;
   a first logic gate configured to receive the flip-flop signal and a first test signal, the first logic gate being configured to output a first output based on a comparison of the flip-flop signal and a first test signal; and
   a second logic gate configured to receive the flip-flop signal and a second test signal, the second logic gate being configured to output a second output based on a comparison of the flip-flop signal and a second test signal,
   wherein the first output of the first scan flip-flop device is provided as the data signal received by the second scan flip-flop device, and wherein the scan enable signal, first test signal and second test signal are independently configurable; and
a PLOS synchroniser configured to provide a synchronised scan enable signal to the first scan flip-flop device of the multi-bit scan flip-flop device such that the selective output of multiplexer is synchronised with the clock signal.

The PLOS synchroniser may be further configured to provide the synchronised scan enable signal to the second scan flip-flop device of the multi-bit scan flip-flop device.

The combination of one or more scan flip-flip devices and a PLOS synchroniser as per the present disclosure may advantageously simplify the timing requirements associated with scan testing. The integrated PLOS synchroniser and scan flip-flop (which may be referred to as SynchroFlop) may reduce some of the difficulties in managing scan enable synchronisation trees associated with conventional scan devices (e.g., when the clock signal frequency changes from ow to high frequency).

In general, a synchroniser may be used to drive a scan enable tree - i.e., a scan enable signal that is shared or 'branched' to a number of flip-flop devices within the scan chain. However, the tree must be precisely timed and balanced so that the scan enable signal is correctly synchronised. The SynchroFlop of the present disclosure may alleviate these strict timing limits (due, in part, to the synchroniser being integrated within the flip-flop device) and eliminate the need to balance a scan enable synchronisation tree.

The PLOS synchroniser may be particularly suitable for very high frequency logic that needs to be scan testable with at-speed transition test, due to very high test coverage requirements. Conventional devices that generate the scan enable signal may not support high frequency signals. Thus, generating a scan enable signal that is capable of switching at-speed may be simplified by the PLOS synchroniser of the present disclosure. The additional circuitry overheads associated with the PLOS synchroniser (compared to an ordinary scan flip-flop, like that of Figure 1) may be more than offset by the above advantages, particularly in smaller safety-relevant modules (e.g., phase-locked loop counters operating in the GHz range).

According to a fifth aspect, there is provided a method of operating a circuit comprising a scan flip-flop device, the scan flip-flop device comprising:
a multiplexer configured to receive a data signal, a scan input signal and a scan enable signal, the multiplexer being configured to selectively output either the data signal or the scan input signal based upon the scan enable signal;
a flip-flop configured to receive the output of the multiplexer and a clock signal, the flip-flop being configured to output a flip-flop signal based on a state of the flip-flop;
a first logic gate configured to receive the flip-flop signal and a first test signal, the first logic gate being configured to output a first output based on a comparison of the flip-flop signal and a first test signal; and
a second logic gate configured to receive the flip-flop signal and a second test signal, the second logic gate being configured to output a second output based on a comparison of the flip-flop signal and a second test signal.

The method comprises:
individually configuring each of the scan enable signal, the first test signal and the second test signal such that a desired operating condition is applied to the scan flip-flop device; and
analysing at least one of the first output and the second output to determine an operational status of the scan flip-flop device.

The desired operating condition may correspond to one of:
a functional mode wherein the first output is provided to combinational logic;
a high temperature operation life, HTOL, testing mode;
a logic built-in self-test, LBIST, mode; and
a bias temperature instability, BTI, recovery mode.

Individually configuring each of the scan enable signal, the first test signal and the second test signal may comprise using Automatic Test Pattern Generation, ATPG, software to produce desired test bits.

The circuit may comprise at least a first scan flip-flop device and a second scan flip-flop device.

The combination of the above method with the devices of the present disclosure may be particularly advantageous. According to a general aspect, a pair of logic gates coupled to the output of a flip-flop may be independently configured via a pair of test control signals. The test control signals and a scan enable signal may be set independently in order to provide a number of different operational and/or functional modes. These modes may be performed using an integrated synchroniser/scan flip-flop device, thereby providing for a wider test coverage (e.g., HTOL, LBIST, PLOS) whilst relaxing the timing requirements associated with at-speed testing.

These and other aspects of the disclosure will be apparent from, and elucidated with reference to, the embodiments described hereinafter.

### Brief description of Drawings

Embodiments will be described, by way of example only, with reference to the drawings, in which:
Figure 1 is a schematic diagram of an example scan flip-flop;
Figure 2 is a schematic diagram of an example scan flip-flop device according to the present disclosure;
Figure 3a is a schematic diagram of an example multi-bit scan unstitched flip-flop device according to the present disclosure;
Figure 3b is a schematic diagram of an example multi-bit scan stitched flip-flop device according to the present disclosure;
Figure 4 is a table of results demonstrating various inputs and outputs for a scan flip-flop device according to the present disclosure;
Figure 5 is a schematic diagram of an example pseudo-launch-off-shift (PLOS) synchroniser; and
Figure 6 is an illustrative timing diagram of various transition delay tests.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar features in modified and different embodiments.

### Detailed description of embodiments

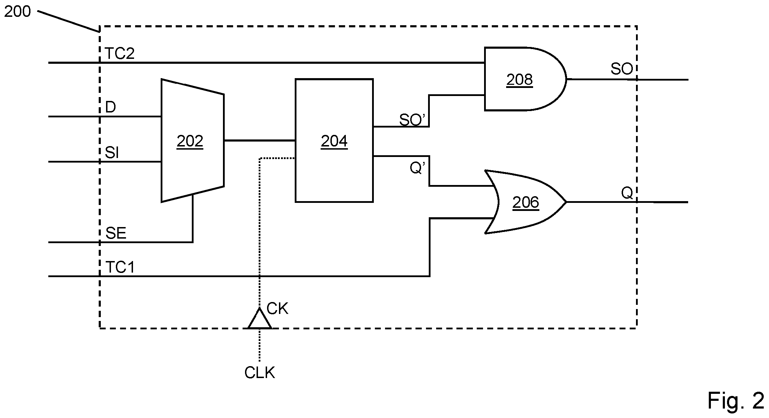

Figure 2 schematically illustrates a scan flip-flop device 200. As with the example illustrated in Figure 1, a data signal D and a scan input signal SI are provided to a 2X1 multiplexer 202. The output of the multiplexer 202 is determined by a scan enable signal SE. When the scan enable signal is in a first state (e.g., a high logic or binary 1) the multiplexer 202 will pass the scan input signal SI. When the scan enable signal SE is in a second state (e.g., a low logic or binary 0) the multiplexer 202 will pass the data signal D. The output of the multiplexer 202 is provided to a flip-flop 204, along with a clock signal CK provided from an external clock reference signal CLK.

The flip-flop 204 may be any suitable flip-flop component that has a bistable state, such as a D-type flip-flop (a delay flip-flop). The flip-flop 204 may be provided with a reset pin/port (not shown) configured to reset the state of the flip-flop 204. A separate reset signal may be selectively applied to the reset pin of the flip-flop 204, thereby returning the flip-flop to a default state.

The output of the flip-flop 204 is provided to a first logic gate 206 and a second logic gate 208, alongside a first test signal TC1 and a second test signal TC2 respectively. In the example of Figure 2, the first logic gate 206 is an OR gate and the second logic gate 208 is an AND gate. The first logic gate 206 outputs a first output Q and the second logic gate outputs a second output SO. The scan flip-flop device 200 is provided with additional pins for TC1 and TC2, and separate dedicated pins for the two outputs Q and SO, compared to the scan flip-flop 100 of Figure 1.

In essence, the scan flip-flop device 200 of Figure 2 may be regarded as a scan flip-flop device like that of Figure 1 with logic gates inserted following the flip-flop to provide gated Q and SO outputs. In the example of Figure 2, the OR gate 206 receives a raw Q output, Q', from the flip-flop 204 (to provide a gated Q output) and the AND gate 208 receives a raw SO output, SO', from the flip-flop 204 (to provide a gated SO output). Providing individually controllable test signals TC1, TC2 to the logic gates 206, 208 respectively of the scan flip-flop device 200 enables power gating of the flip-flop outputs, which may reduce the power consumption of a circuit in which the scan flip-flop device 200 is integrated. Provision of individually controllable test signals TC1, TC2 may also enable greater test coverage by appropriately modifying/controlling the scan flip-flop device output to suit certain test criteria (discussed further below).

One or more scan flip-flop devices 200 may be used in a circuit. Where the circuit comprises scan flip-flops 100 that lack logic gates 206, 208 at the output, all or some of said scan flip-flop 100 may be replaced by scan flip-flop devices 200 according to the present disclosure. In particular, high-impact flip-flops - i.e., those flip-flops that significantly contribute to the overall switching power (because they are connected to inputs of the combinatorial logic that controls a large number of nodes) - may be replaced by the scan flip-flop devices 200 of the present disclosure.

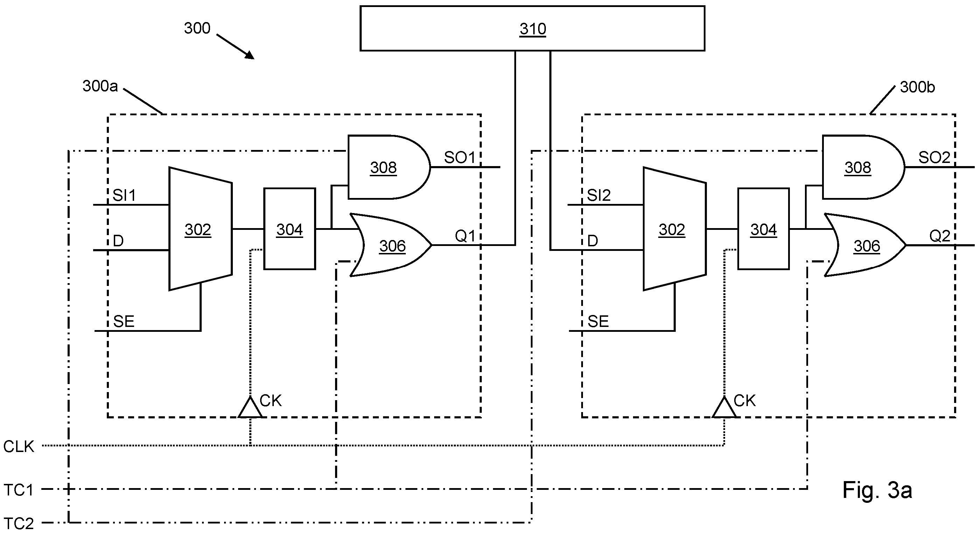

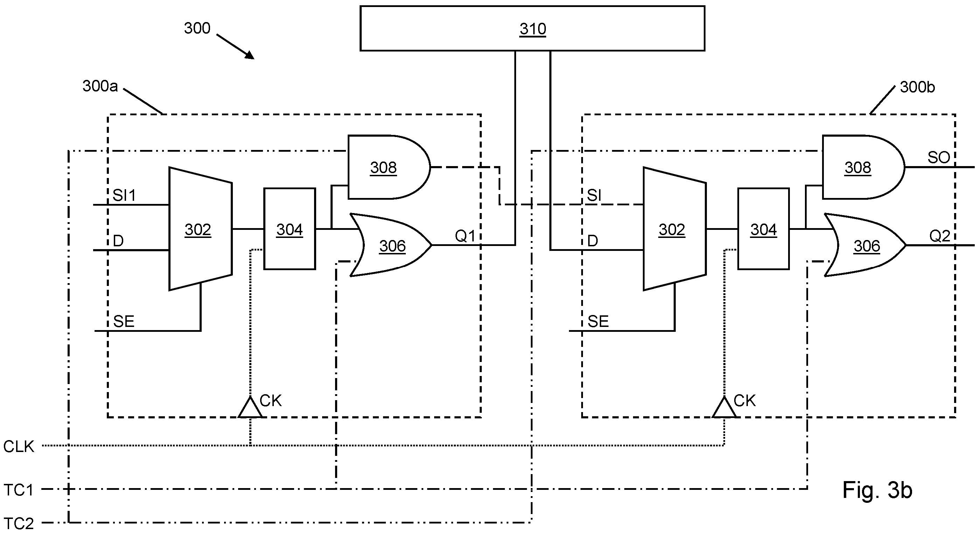

Figures 3a and 3b both schematically illustrate a multi-bit scan flip-flop device 300 comprising a first scan flip-flop device 300a and a second scan flip-flop device 300b that are coupled together to form a scan chain segment. Many such segments may be coupled together to produce a full scan chain. Each of the scan flip-flop devices 300a, 300b comprises components similar to the example scan flip-flop device of Figure 2, with similar connections within each scan flip-flop device 300a, 300b. Each scan flip-flop device 300a, 300b comprises a multiplexer 302, a flip-flop 304, an OR gate 306 and an AND gate 308. The outputs of the flip-flops 304 are provided to the two logic gates 306, 308.

Each of the scan flip-flop devices 300a, 300b are provided with a common clock signal CLK, first test control signal TC1 and second test signal TC2. The first output Q1 of the first scan flip-flop device 300a and the data signal D input of the second scan flip-flop device 300b are coupled to combinational logic 310, the combinational logic providing the scan flip-flop devices with data inputs when operating in a functional mode.

In the example of Figure 3a, the multi-bit scan flip-flop device 300 is not internally stitched; the scan flip-flop devices 300a, 300b have separate scan inputs SI1, SI2 and second scan outputs SO1, SO2. The multi-bit scan flip-flop device 300 may comprise additional pins for all or some of these additional inputs and outputs.

The multi-bit scan flip-flop device 300 of Figure 3b is similar to that of Figure 3a. However, the multi bit scan flip-flop device 300 of Figure 3b is internally stitched; the second output of the first scan flip-flop device 300a (from AND gate 308) is provided as the scan input signal SI to the multiplexer 302 of the second scan flip-flop device 300b. Consequently, there is only a single scan input signal SI provided at the first scan flip-flop device 300a, which is propagated through each of the scan flip-flop devices 300a, 300b of the scan chain segment to provide a single scan output SO at the second scan flip-flop device 300b.

In general, the flip-flops of each of the scan flip-flop devices 300a, 300b provide a flip-flop signal output comprising a Q and an SO component (each of which are gated by logic gates 306, 308 respectively). The first output Q forms a functional path; it is provided to the combinational logic 310. The second output SO is a scan output signal that forms the scan chain path when the multi-bit scan flip-flop device 300 is internally stitched.

Although Figures 3a and 3b show the multi-bit scan flip-flop devices 300 as having two constituent scan flip-flop devices 300a, 300b, it will be understood that any plurality of scan flip-flop devices may be coupled to the scan chain dependent upon the application. The relevant inputs, outputs and interconnections between the numerous scan flip-flop device will be similar to those shown in the above examples.

The scan enable signal SE, first test control signal TC1 and second test control signal TC2 may be controlled individually as part of an Automatic Test Pattern Generation (ATPG)-based method that is used to control the scan flip-flop devices 300a, 300b. Scan test patterns (i.e., the binary values that are shifted into the scan chain) that are generated using ATPG methods may be applied using a JTAG controlled Test Data Register (TDR) block. The TDR block comprises shift-register logic that is used to control the scan flip-flop devices 300a, 300b.

When the scan enable signal SE is set to '0', the scan flip-flop devices 300a, 300b are configured in a functional mode and the scan input signal SI is effectively disconnected. The scan flip-flop devices 300a, 300b receive an input from the data signal D (which may be provided by combinational logic circuitry). When the scan enable signal SE is set to '1', the scan flip-flop devices 300a, 300b are configured in a test mode and the data signal D is effectively disconnected. The scan flip-flop devices 300a, 300b receive an input from the scan input signal SI comprising test input bits. The testing comprises four main phases:
I. Shift-in: The test input bits are loaded into each of the scan flip-flop devices 300a, 300b. The number of clock cycles required to load the test input bits is equal to the number of flip-flops in the scan chain.
II. Launch: During the last clock cycle of the shift-in phase, the outputs of the scan flip-flop devices 300a, 300b are applied to the combinational logic.
III. Capture: The test input bits applied to the flip-flops are captured.
IV. Shift-out: The switched values of each of the flip-flops are serially transferred to the output SO. This also requires the same number of clock cycles as the number of flip-flops in the scan chain.

The SE, TC1 and TC2 may be configured independently so as to provide various gating modes to test for various faults of the scan flip-flop device. Combinations of said signals are shown in Table 1, along with a description of what mode each of these combinations may correspond to. As shown in Table 1, the scan flip-flop device can be operated a functional mode and a scan/test mode to provide additional robustness and/or test coverage.

High Temperature Operation Life (HTOL) testing provides an indication of the reliability of the circuit, by providing a 'stress test' with high voltage and/or higher temperature. By toggling the output power provided from the scan flip-flop devices' logic gates, such conditions may be enabled by the present disclosure.

Bias Temperature Instability (BTI) recovery may provide additional robustness to the scan flip-flop device of the present disclosure. During certain operating modes/test conditions, charge carriers may become trapped in the dielectric of the gate isolation of the transistors in the flip-flop, thus changing the threshold voltage at which it is switched. A clock signal may be provided as a test signal in order to reduce the BTI effects and enable more effective recovery. The clock signal CLK may be provided to the first test signal TC1 to provide BTI recovery for combinational logic (e.g., after a sleep mode). The clock signal CLK may be provided to the second test signal TC2 to provide BTI recovery for a scan chain (e.g., before testing).

Logic built-in self-test (LBIST) may be facilitated by the scan infrastructure of the present disclosure, thereby providing fault detection for an IC in which the scan flip-flop devices are integrated. This may be used to detect latent faults that were undetected during production but have been worsened during the lifetime of the IC. The test signals TC1, TC2 enable gating of the scan flip-flop devices' 300a, 300b output power which may reduce power demand during self-testing. Additional resilience for LBIST may be provided by the present disclosure. In some cases, a low dropout regulator (LDO) voltage at the end of the shift-in phase overshoots and then undershoots at the beginning of the capture phase (due to the LDO adapting to the lower current in the clock-off phase). Thus, transition test capture is done at a higher or lower voltage than intended, thereby resulting in too optimistic or pessimistic testing (which may result in test escapes orfalse alerts respectively). The devices of the present disclosure enable a more consistent LDO voltage during this transition by providing warm-up pulses via the second test signal TC2, thereby providing test conditions that more realistically represent expected conditions during functional operation. The LDO forms part of the supply voltage path (not shown) that is used to provide power to the IC, and is separate from the various functional/scan signals.

**Table 1: Scan flip-flop device input signals and corresponding impact**

| **Use case** | **Signal** | | | **Impact** |
|---|---|---|---|---|
| | **SE** | **TC1** | **TC2** | |
| Usual Application | 0 | 0 | 0 | Standard application mode, power consumption is reduced as SO is gated. |
| Production scan shift | 1 | 1 | 1 | Standard scan test in production, power consumption is reduced as Q is gated during shift mode |
| HTOL / Burn-in | 0/1 | 0 | 1 | Maximum toggle activity on a maximum number of nodes to improve HTOL efficiency, as part of Early Life Failure Rate (ELFR) testing |
| Warm-up | 0 | CLK | CLK | Exerting activity for several clock cycles to prepare the LDO for higher current demands during transition capture cycle |
| LBIST / margin | 0/1 | 0 | 1 | LBIST to exert extra stress on power supply wires to early detect weakening supply wires, vias, LDOs, etc. |
| LBIST / plain | 0/1 | 1 | 1 | LBIST according to specification; hence without extra stress of supply wires; as confirmation in case the margin LBIST fails |
| BTI recovery | 0 | CLK | 0 | Recovery from BTI after LBIST, stand-by, power-down of certain modules, etc. |
| Stand-by / Power-Save | 0 | 1 | 0 | Keeping logic in sleep mode for power saving |
| PLOS | 0/1 | 0 | 1 | Local PLOS transition scan test |

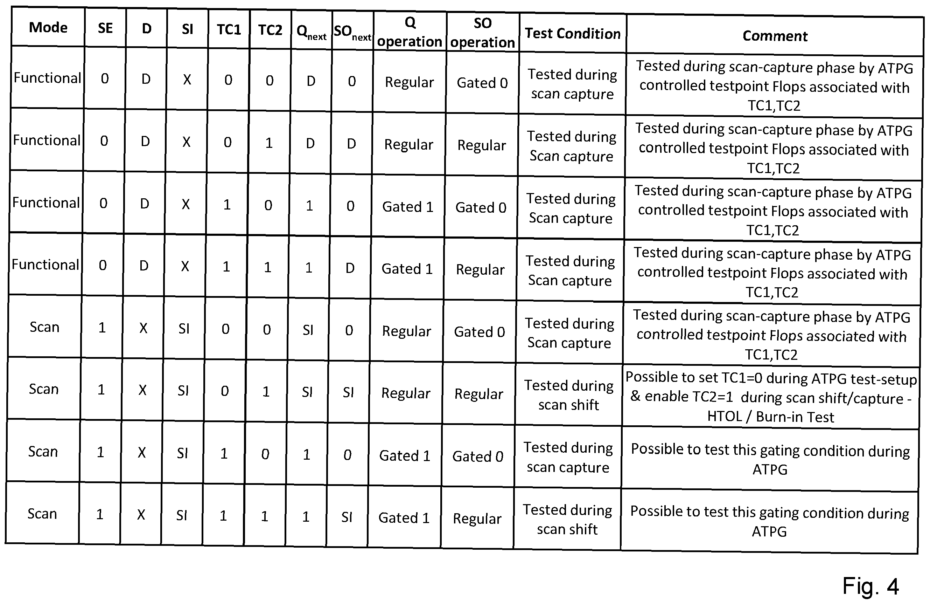

Figure 4 provides a table illustrating the various inputs/outputs of a scan flip-flop device. The results therein demonstrate the impact the first test signal TC1 and second test signal TC2 have on the first output Q and second output SO of the device, for both functional (scan enable signal = '0') and scan/test (scan enable signal = '1') modes. In the table of Figure 4, an active edge of the CK input is assumed (i.e. one clock pulse per cycle) and 'X' indicates that the input value does not matter. For the Q and SO outputs, the 'next' subscript indicates that the relevant signal has been synchronised by the clock signal (due to the launch/capture phases).

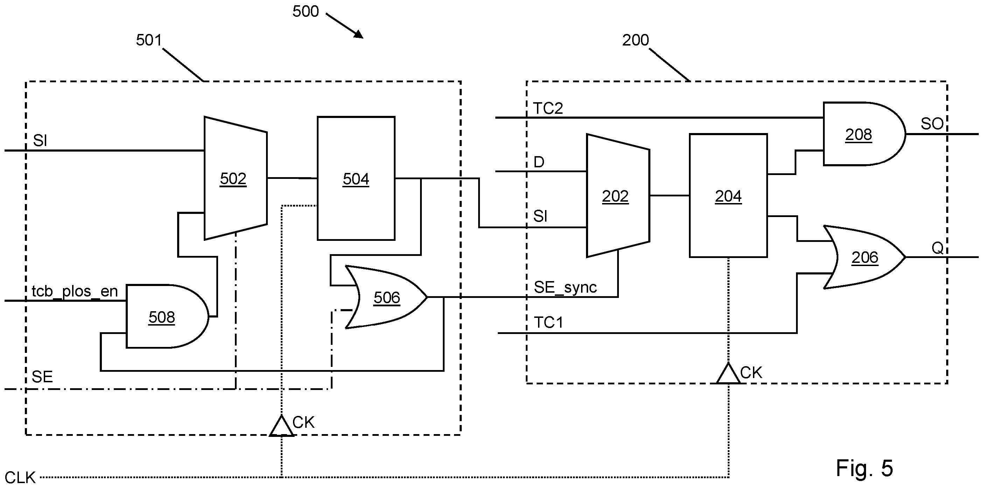

Figure 5 schematically illustrates a Pseudo-Launch-off-Shift (PLOS) circuit 500 (which may be referred to as a SynchroFlop). The PLOS circuit comprises a scan flip-flop device 200 (like that described in Figure 2) and a synchroniser 501.

The synchroniser 501 comprises a multiplexer 502, the output of which is received by a flip-flop 504 (along with a clock signal CK). An output signal of the flip-flop 504 is provided to the multiplexer 202 of the scan flip-flop device 200. A first logic gate 506 (in the example of Figure 5, an OR gate) also receives the output signal of the flip-flop 504, alongside a scan enable signal SE. The first logic gate 506 of the synchroniser 501 provides a synchronised scan enable signal SE_sync to the multiplexer 202 of the scan flip-flop device 200. A second logic gate 508 (in the example of Figure 5, an AND gate) also receives the synchronised scan enable signal SE_sync, alongside a PLOS test control bit data signal tcb_plos_en. The second logic gate 508 provides an input data signal to the multiplexer 502 of the synchroniser 501. The synchroniser 501 ensures that the transition of the scan enable signal that is provided to the scan flip-flop device 200 is synchronised with the clock, thereby resulting in an appropriate transition between scan mode and functional mode for at-speed testing. The combination of such a synchroniser 501 and scan flip-flop device 200 may reduce the precision requirement for external automatic test equipment (ATE) as the precision requirement of transition timing limits is reduced (as the relevant signals are synchronised by the integrated synchroniser 501). The power gating advantages and synergies associated with the scan flip-flop device 200 discussed above are also evident in the PLOS transition testing. Additionally, gating of the synchroniser (such as Q-gating) may be eliminated.

As the PLOS synchroniser 501 and the scan flip-flop device 200 are integrated in the same PLOS circuit 500, timing of the synchronised scan enable signal SE_sync may be simplified. In particular, the device may eliminate the need to balance a scan enable synchronisation tree across multiple flip-flop devices.

The PLOS circuit 500 may eliminate the need for anti-skew devices compared to devices that use a synchroniser to drive a scan enable synchronisation tree. Without the use of an integrated device like the PLOS circuit 500, anti-skew devices (such as an anti-skew flip-flop) may be required to reduce/eliminate skew that can may arise in the scan enable signal - i.e., the scan enable signal may otherwise be delayed or fast-arriving, thereby causing incorrect capture operation. In general, the PLOS circuit 500 may relax the timing requirements for providing the scan enable signal.

Although the PLOS circuit 500 of Figure 5 comprises only one scan flip-flop device 200, it will be understood that further scan flip-flop devices may be added to form a scan chain, similar to that shown in Figure 3. Each scan flip-flop device 200 may be synchronised using the SE_sync signal.

The benefits of the PLOS circuit 500 discussed above may also apply to such a device comprising multiple scan flip-flop devices (i.e., a multi-bit PLOS circuit). In such an example, the timing requirements may be more substantially reduced compared to non-integrated devices, as the single synchroniser 501 may be used to synchronise multiple scan flip-flop devices.

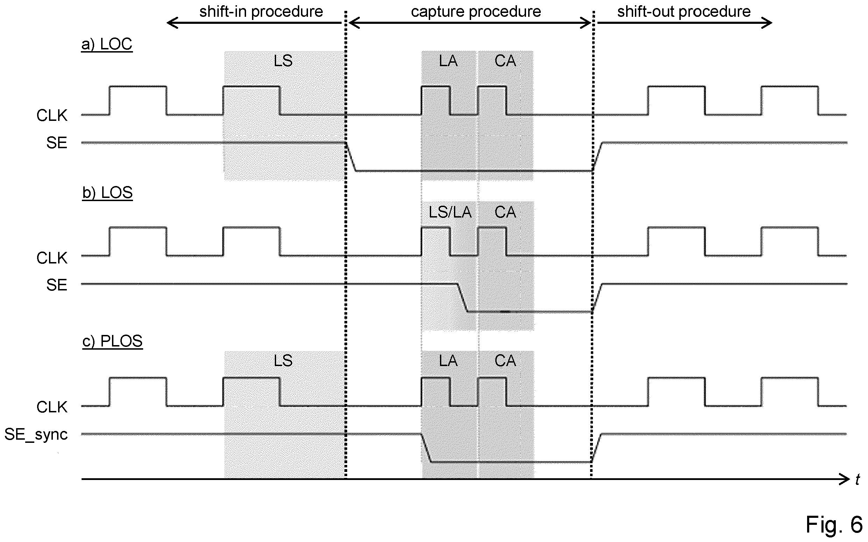

Figure 6 shows timing diagrams for different transition delay test mechanisms that may be used to test the scan flip-flop devices of the present disclosure. The mechanisms shown are: a) Launch-off-Capture (LOC), b) Launch-off-Shift (LOS), and pseudo-Launch-off-Shift (PLOS). The clock signal CLK and scan enable signal SE are shown for each of the mechanisms across a time interval t, with high and low logic (binary 1 and 0). Each of the mechanisms comprise three main procedures: i) a shift-in procedure, where the test input bits are shifted into the scan flip-flop devices (phase I 'Shift-in' discussed above); a capture procedure where the outputs are applied to the combinational logic and then the test output captured (phases II 'Launch' and III 'Capture' discussed above); and the shift-out procedure where the switched values of each of the flip-flops are shifted out (phase IV 'Shift-out' discussed above).

While the shift-in procedure and shift-out procedure can be conducted slowly, with one test bit being shifted per clock cycle, the capture procedure must be performed at functional frequency, which is usually higher than the shift clock frequency. This allows the IC to be tested at operating frequencies, such that the transition test analyses whether the output change of the flip-flop resulting from the launch phase occurs fast enough to be captured during the capture phase (or whether the transition is passed over).

In LOC, the scan enable signal SE is switched to 0 following the last shift cycle LS of the shift in procedure; all *N* test bits are shifted before the transition. Only after this are two functional clock cycles used for launch LA and capture CA. The delay between LS and LA in LOC means that there is sufficient time for scan enable signal SE to transition from 1 to 0 and timing of the transition is not critical. However, LOC has a limited test coverage because the ATPG has less degrees of freedom for setting the flip-flop values in the launch cycle.

By contrast, in LOS only the first *N*-1 test bits are shifted during the shift-in phase. The last shift LS is itself used to trigger the SE transition on the first functional clock cycle. This means that the transition of the SE signal is critical in LOS, but enables LOS to have a greater test coverage. The switching of the SE signal needs to be synchronized with the last shift clock pulse of the scan flip-flop (as shown in Figure 6). As a result, the testing procedure needs to be timed to ensure synchronization between the switching of the SE signal and the last shift clock pulse (launch clock pulse). This requirement leads to some extra effort, which may be minimised by the synchronizer (501) solution.

The synchroniser 501 described in Figure 5 enables the SE_sync signal that is provided to the scan flip-flop device to be synchronised with the clock signal CLK. This provides for PLOS transition fault testing, wherein the switching of the flip-flop between scan and functional mode is synchronised with launch, as shown in Figure 6. This simplifies the timing requirements associated with conducting the transition test using LOS, while still providing for a greater test coverage than that available using LOC.

The PLOS operation described above for the device of Figure 5 may be implemented in such a way that the timing behaviour of the resulting hard-macro can be described using a standard timing view file (e.g., a .lib file). The timing closure, e.g., the requirements placed on the timing of the scan enable single, may be easier to implement than with alternative devices, as SyncroFlop is a hardened macro; the implementation of the synchroniser and the scan flip-flop device is determined by the hardware.

The disclosure relates to a scan flip-flop device and associated methods for operating a circuit comprising a scan flip-flop device. An example scan flip-flop device comprises: a multiplexer configured to receive a data signal, a scan input signal and a scan enable signal; a flip-flop configured to receive the output of the multiplexer and a clock signal, a first logic gate configured to receive the flip-flop signal and a first test signal; and a second logic gate configured to receive the flip-flop signal and a second test signal, wherein the scan enable signal, first test signal and second test signal are independently configurable.

From reading the present disclosure, other variations and modifications will be apparent to the skilled person. Such variations and modifications may involve equivalent and other features which are already known in the art of flip-flop circuits, and which may be used instead of, or in addition to, features already described herein.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Features which are described in the context of separate embodiments may also be provided in combination in a single embodiment. Conversely, various features which are, for brevity, described in the context of a single embodiment, may also be provided separately or in any suitable sub-combination. The applicant hereby gives notice that new claims may be formulated to such features and/or combinations of such features during the prosecution of the present application or of any further application derived therefrom.

For the sake of completeness it is also stated that the term "comprising" does not exclude other elements or steps, the term "a" or "an" does not exclude a plurality, a single processor or other unit may fulfil the functions of several means recited in the claims and reference signs in the claims shall not be construed as limiting the scope of the claims.

## Claims

1. A scan flip-flop device comprising:
a multiplexer configured to receive a data signal, a scan input signal and a scan enable signal, the multiplexer being configured to selectively output either the data signal or the scan input signal based upon the scan enable signal;
a flip-flop configured to receive the output of the multiplexer and a clock signal, the flip-flop being configured to output a flip-flop signal based on a state of the flip-flop;
a first logic gate configured to receive the flip-flop signal and a first test signal, the first logic gate being configured to output a first output based on a comparison of the flip-flop signal and a first test signal; and
a second logic gate configured to receive the flip-flop signal and a second test signal, the second logic gate being configured to output a second output based on a comparison of the flip-flop signal and a second test signal,
wherein the scan enable signal, first test signal and second test signal are independently configurable.

2. The scan flip-flop device of claim 1, wherein the first logic gate is an OR gate.

3. The scan flip-flop device of claim 1 or 2, wherein the second logic gate is an AND gate.

4. The scan flip-flop device of any preceding claim, wherein the flip-flop comprises a reset pin configured to reset the state of the flip-flop in response to a reset signal.

5. A multi-bit scan flip-flop device comprising at least a first scan flip-flop device according to any preceding claim and a second scan flip-flop device according to claim any preceding claim, wherein the first output of the first scan flip-flop device and the data signal received by the second scan flip-flop device are coupled to combinational logic such that the first scan flip-flop device outputs to the combinational logic and the second scan flip-flop device receives an input from the combinational logic when the multi-bit scan flip-flop device is operated in a functional or scan capture mode.

6. The multi-bit scan flip-flop device of claim 5, wherein each of the scan flip-flop devices are provided with an individual scan input signal.

7. The multi-bit scan flip-flop device of claim 5 or 6, wherein the second output of the first scan flip-flop device is provided as the scan input signal received by the second scan flip-flop device.

8. The multi-bit scan flip-flop device of any of claims 5 to 7, wherein the scan enable signals provided to the first scan flip-flop device and second scan flip-flop device are synchronised using an integrated synchroniser.

9. A pseudo-launch-off-shift (PLOS) circuit comprising:
a scan flip-flop device according to any preceding claim; and
a PLOS synchroniser configured to provide a synchronised scan enable signal to the scan flip-flop device such that the selective output of multiplexer is synchronised with the clock signal.

10. The PLOS circuit of claim 9, wherein the first logic gate is an OR gate and the second logic gate is an AND gate.

11. A multi-bit pseudo-launch-off-shift (PLOS) circuit comprising:
a multi-bit scan flip-flop device according to any of claims 5 to 10; and
a PLOS synchroniser configured to provide a synchronised scan enable signal to the first scan flip-flop device of the multi-bit scan flip-flop device such that the selective output of multiplexer is synchronised with the clock signal.

12. The multi-bit PLOS circuit of claim 9, wherein the first logic gate of each of the first and second scan flip-flop devices is an OR gate and the second logic gate of each of the first and second scan flip-flop devices is an AND gate.

13. The PLOS circuit of claim 11, wherein the PLOS synchroniser is further configured to provide the synchronised scan enable signal to the second scan flip-flop device of the multi-bit scan flip-flop device.

14. A method of operating a circuit comprising a scan flip-flop device, the scan flip-flop device comprising:
a multiplexer configured to receive a data signal, a scan input signal and a scan enable signal, the multiplexer being configured to selectively output either the data signal or the scan input signal based upon the scan enable signal;
a flip-flop configured to receive the output of the multiplexer and a clock signal, the flip-flop being configured to output a flip-flop signal based on a state of the flip-flop;
a first logic gate configured to receive the flip-flop signal and a first test signal, the first logic gate being configured to output a first output based on a comparison of the flip-flop signal and a first test signal; and
a second logic gate configured to receive the flip-flop signal and a second test signal, the second logic gate being configured to output a second output based on a comparison of the flip-flop signal and a second test signal,
the method comprising:
individually configuring each of the scan enable signal, the first test signal and the second test signal such that a desired operating condition is applied to the scan flip-flop device; and
analysing at least one of the first output and the second output to determine an operational status of the scan flip-flop device.

15. The method of claim 14, wherein the desired operating condition corresponds to one of:
a functional mode wherein the first output is provided to combinational logic;
a high temperature operation life (HTOL) testing mode;
a logic built-in self-test (LBIST) mode; and
a bias temperature instability (BTI) recovery mode.
